# EUROPEAN PATENT APPLICATION

(11) **EP 1 339 272 A1**
(43) Date of publication of application: **27.08.2003**
(21) Application number: 01980554.8
(22) Date of filing: 31.10.2001
(51) Int. Cl.: H05K 5/02, H01R 13/73

(54) **SYSTEM FOR FIXING THE ELECTRICAL CONNECTION BOXES TO THE STRUCTURE OF VEHICLES**

(30) Priority: 31.10.2000 ES 200002657 U
(71) Applicant: Lear Automotive (EEDS) Spain, S.L., 43800 Valls, Tarragona (ES)
(72) Inventor: IGUAZ, Javier, E-43800 Valls (ES)
(74) Representative: Primo de Rivera y Urquijo, Jose Antonio
(86) International application number: ES0100412
(87) International publication number: WO02037913

(57) **Abstract**

A multiple fixing system for vehicle components consisting of a fixing system or device permitting different electric components, mainly service boxes, to be anchored and fixed to the chassis of any type of vehicle, thus standardizing the different types of service box chassis fixings.

## Description

### OBJECT OF THE INVENTION

The present invention, a multiple fixing system for vehicle components, refers to a device or fixing system permitting anchoring and fixing different electric components, mainly service boxes, to the chassis of any type of vehicle, thus standardizing the different types of chassis service boxes fixings.

### BACKGROUND OF THE INVENTION

The boxes currently existing on the market and therefore considered the State of the Art are fixed to the vehicle in two ways, either by means of screws or by means of pressure.

Fixing the box to the vehicle by means of screws permits a firm and secure anchorage of the box base to the vehicle, but its main drawback is that anchoring requires too much time due to the different points coupling the box to the vehicle.

Fixing the box to the vehicle by means of exerting heavy pressure on the box requires a special vehicle chassis base so that the box fixes and stays fixed. A drawback of this assembly is if the vehicle is hit in a determined area, the box may detach from the chassis, provoking unwanted break downs in its functioning, a reason for which this type of assembly is not in use.

With the increasing use of platforms in the automobile industry, we see the growing problem of fixing the same component to different vehicles, making it necessary to amend the pieces to be fixed for each of the elements and type of vehicle in function of the type of component and its location in the vehicle, as well as the space available in the vehicle for this purpose.

Each vehicle currently has different spaces and component distribution which obliges designing a particular service box for each vehicle model. This increases the price of the process due to the fact that one type of service box cannot be standardized so that it is common for the majority of the different vehicle models being manufactured.

To solve this problem, a new fixing system has been conceived, serving to couple electric components to different vehicle types without needing to change the fixing systems and obtaining a multiple fixing system, changing only one support piece for coupling the component to the vehicle.

The present invention will be very useful in fixing service boxes to the vehicle chassis. As service boxes cannot be homogenous due to the different vehicle configurations and the different service box locations, the present invention homogenizes the manner of fixing the boxes, preventing having to also adapt the fixing system to the type of box and vehicle. The three main features of the invention are:
- standardizing vehicle service boxes in spite of where they are located since they have a support permitting assembly in any space reserved for assembling said boxes,
- reducing manufacturing costs of the service boxes due to their standardization, and
- reducing the time needed to assemble service boxes on the chassis.

### DESCRIPTION OF THE INVENTION

The new proposed fixing system incorporates a double guide bracket on the base of the component or box to be fixed to the vehicle, having a determined number of teeth permitting the component to be fixed onto the vehicle once a fixing piece is introduced through the double guide bracket by means of friction, fixing the component onto the vehicle.

The fixing element or piece could be metal, plastic or any other valid material and is configured according to the 5 shape and dimensions of the component to fix. Its largest surface, which will be horizontally fixed onto the base of the component or box, has the shape of a square, open on one of its ends, leaving two of its sides free, which will be introduced into the double guide bracket of the component base by means of friction, joining the component and fixing element.

This fixing element will have a broader surface on the side opposite the opening, of the same width as the component to be fixed, bending downward on its sides for the purpose of enveloping the component or service box sides, obtaining a better fixing, and then bending upward to leave space for a hole permitting the fixing piece to be anchored to the vehicle by means of introducing a screw.

Once the fixing piece is introduced into the double guide bracket on the component base by means of friction, it will be completely secured thanks to four butts arranged on the base, two of them on the farthest end and coinciding with respective holes arranged on the ends of the free sides of the fixing piece, and two others arranged on the nearest end, behind the fixing piece once it is introduced in the double guide bracket, preventing the fixing piece from coming out of its housing.

### BRIEF DESCRIPTION OF THE DRAWINGS

To facilitate the understanding of the multiple fixing system for vehicle components, two drawings are attached to the present invention for the purpose of better understanding the fundamentals the invention concerning us is based on, and to better understand the description of a preferred embodiment of the invention. The drawings included are of an illustrative and non-limiting character.

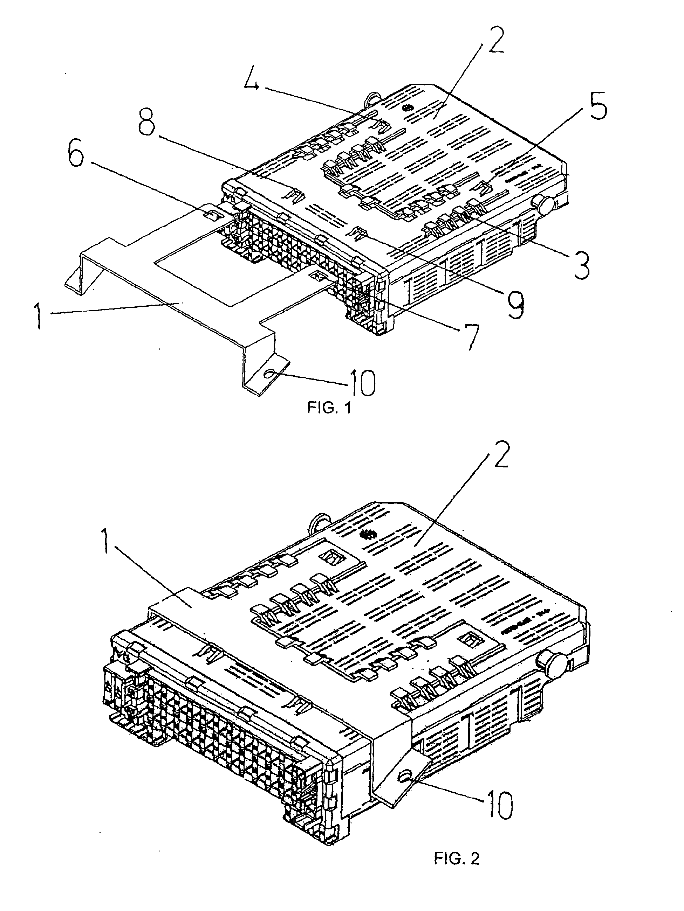

Figure 1 shows an upper view of the component base and fixing piece.

Figure 2 shows an upper view of the component base with the fixing piece introduced in the double guide bracket.

### DESCRIPTION OF A PREFERRED EMBODIMENT OF THE INVENTION

The multiple fixing system for vehicle components proposed by the invention has a fixing element 1 that can be of metal, plastic or any other material complying with the required mechanical demands. Said fixing element 1 is formed by a U-shaped element, so that the two flat, elongated elements originate from a flat side base, which is also perpendicularly prolonged to the two flat, elongated elements and on the same plane, then both sides bend downward, perpendicularly to the U-shaped body plane, having a transitional surface and another surface behind having two orifices or holes to introduce a screw.

By means of pressure, the flat, elongated elements are introduced and coupled to the double guide bracket 2 arranged on the component or service box base surface. Said double guide bracket 2 is formed by a determined number of teeth 3, specifically eight pairs of teeth, four facing pairs on each guide bracket, permitting the fixing element 1 to be coupled to the box base.

The component or box base surface 2 will also have four butts formed by a protrusion of the triangular section base, which will prevent the fixing element 1 from coming out of its housing once it is introduced. Two of the butts 4 and 5 are arranged at the end of the base guide bracket 2 determined by the teeth 3 and opposite the side where the fixing element is introduced, and they will be introduced into the holes 6 and 7 located on the end of the flat, elongated fixing element 1.

The other two butts, also a triangular section, 8 and 9 are centrally located on the component or box base 2, and next to the side where the fixing element is introduced.

Once the fixing element 1 is introduced into the double guide bracket 2, and since it will have passed over the butts 8 and 9, the teeth 3 will exert pressure on the fixing element 1, preventing it from coming out of its housing. The butts triangular section permits introducing the fixing element 1 into the box guide bracket 2, but not extracting it since its backward movement is prevented due to the triangular section with one side perpendicular to the box base 2.

Once the fixing element 1 is introduced into the box 2, a screw is introduced through the holes or orifices 10 arranged on the fixing element 1 for this purpose, permitting the fixing system to be screwed onto the vehicle chassis, therefore fixing the component to the vehicle.

## Claims

1. A multiple fixing system for vehicle components intended to fix different electrical vehicle components to the vehicle chassis, such as service boxes, **characterized by** having a double guide bracket (2) on the component base surface, each being formed by a determined number of pairs of teeth (3) facing each other two by two, between which the flat, elongated elements of the U-shaped fixing element (1) are introduced and coupled by means of pressure, said fixing element (1) having two protrusions on the base side perpendicular to the front flat, elongated elements, one on each side of the base, later bending downward, perpendicularly to the U-shaped body plane, having a transitional surface and another surface behind having two orifices or holes (10) to introduce a screw to fix the fixing system to the vehicle chassis.

2. A multiple fixing system for vehicle components according to previous claims, **characterized in that** the component base surface will have four triangular section butts, two of them (4 and 5) located on the side opposite of where the fixing element (1) is introduced and at the end of the guide bracket delimited by the teeth (3) located on the base surface (2), intended to be introduced inside the holes (6 and 7) arranged on the ends of the flat, elongated elements of the fixing element (1), and two other slightly centered butts (8 and 9) located on the component base surface near the side where the fixing element (1) is introduced, preventing its extraction by acting as a butt in the back part of the U-shaped fixing element (1) .
